# EUROPEAN PATENT SPECIFICATION

(11) **EP 1 358 661 B1**
(45) Date of publication and mention of the grant of the patent: **07.04.2010**
(21) Application number: 02711020.4
(22) Date of filing: 07.02.2002
(51) Int. Cl.: H01F 17/00, H01F 27/36

(54) **HIGH Q INDUCTOR WITH FARADAY SHIELD AND DIELECTRIC WELL BURIED IN SUBSTRATE**
HOCH Q-FAKTOR INDUKTIVITÄT MIT IM SUBSTRAT VERGRABENEN FARADAY-SCHIRM UND DIELEKTRISCHER WANNE
BOBINE D'INDUCTANCE A FACTEUR Q ELEVE AVEC CAGE DE FARADAY ET PUITS DIELECTRIQUE NOYES DANS UN SUBSTRAT

(30) Priority: 10.02.2001 US 781014
(43) Date of publication of application: 05.11.2003
(73) Proprietor: International Business Machines Corporation, Armonk, NY 10504 (US)
(72) Inventor: ACOSTA, Raul, White Plains, NY 10605 (US); LUND, Jennifer, c/o IBM UK Ltd, Winchester, Hampshire SO21 2JN (GB); GROVES, Robert, Highland, NY 12528 (US); ROSNER, Joanna, c/o IBM United Kingdom Limited, Winchester, Hampshire SO21 2JN (GB); CORDES, Steven, Yorktown Heights, NY 10598 (US); CARASSO, Melanie, West Pennant Hills, NSW 2125 (AU)
(74) Representative: Burt, Roger James
(86) International application number: PCT/GB2002/000525
(87) International publication number: WO 2002/065490

(56) References cited:
- WO-A-98/50956
- PATENT ABSTRACTS OF JAPAN vol. 2000, no. 04, 31 August 2000 (2000-08-31) & JP 2000 022085 A (TOSHIBA CORP), 21 January 2000 (2000-01-21) & US 2001/045616 A1 (YOSHITOMI) 29 November 2001 (2001-11-29)

## Description

### TECHNICAL FIELD

This invention relates to the design and construction of high-Q inductors within high frequency integrated circuits.

### BACKGROUND

The present environment sees the rapid proliferation of wireless communications and the wireless products such as modems, pagers, 2-way radios, oscillators and cell phones which include integrated circuits (ICs) having inductors which operate at high frequencies. There is pressure to make these products more and more efficient, compact, light weight and reliable at radio frequency and microwave frequency. It is efficient and economically desirable to fabricate the maximum number of required devices and elements, including inductors, in a single IC and to limit the number and type of processing steps to ones which are consistent with those presently practiced in IC manufacturing. Pushing the performance of conventional integrated circuits into the high frequency range reveals limitations that must be overcome in order to achieve the desired goal. The inductor is one area which has been examined for optimization.

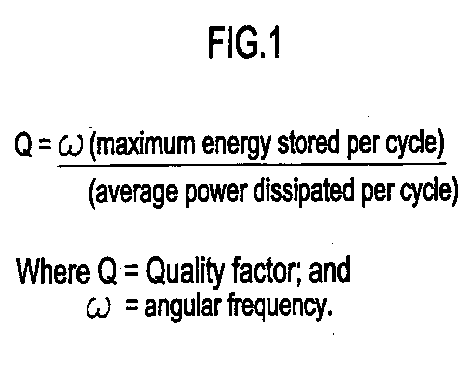

Quality Factor Q is the commonly accepted indicator of inductor performance in an IC. Q is a measure of the relationship between power loss and energy storage in an inductor expressed as an equation shown as Fig. 1. A high value for Q is consistent with low inductor and substrate loss, low series resistance and high inductance. High frequency is considered be greater than about 500 MHz. To achieve a Q of greater than about 10 would be desirable for that frequency range. The technology of manufacturing ICs over silicon substrates is well established. Unfortunately, a planar spiral inductor fabricated in an IC having a silicon substrate typically experiences high losses at RF, and consequently low Q value. Losses experienced are a result of several factors. Electromagnetic fields generated by the inductor adversely affect the semiconducting silicon substrate as well as devices and conductive lines of which the IC is comprised. The result of this interaction is loss due to coupling, cross talk noise, resistance, parasitic capacitance, reduced inductance and lowering of Q values. Elements of Q with respect to a specific spiral conductor over a silicon substrate are set forth in US patent 5,760,456, col. 1, line 55 - ff.

One approach to improving the Q factor is to alter the materials of which the IC is comprised. Using substrates other than silicon, such as GaAs and sapphire is possible. However, it would be desirable to maintain manufacturing processes which are as compatible as possible with existing silicon technology, which is well established, rather than to introduce the process changes and to deal with the attendant problems associated with the use of non-silicon substrate materials.

US patent 6,046,109 to Liao et al. describes one approach to improving Q of an IC on a silicon substrate - the creation of isolating regions to separate the inductor from other regions or devices that would otherwise be adversely affected. The isolating regions are created by radiation of, for example, selected silicon semiconductor regions with a high energy beam such as x-rays or gamma rays or by particles such as protons and deuterons, which results in an increase in resistivity of the irradiated area. The depth of penetration of the radiation can be as deep as required to reduce noise, line loss and assure device separation.

Another approach to improving the Q factor is to alter the shape and dimensionality of the inductor itself in order to overcome inherent limitations of the flat spiral inductor. US patent 6,008,102 to Alford et al. describes two such shapes, toroidal and helical, which are formed in such a way as to align magnetic fields generated by RF currents within the shaped inductor, thereby minimizing dielectric losses, cross talk and increasing Q.

US patents 6,114,937, 5,884,990,5,793,272 and 6,054,329 to Burghartz et al. describe high Q toroidal and spiral inductors with silicon substrate for use at high frequencies. There are described several embodiments which focus on raising Q by increasing inductance. Devices described that are incorporated in the IC in order to raise Q include: a substrate coated with a dielectric layer having a spiral trench which is capped and lined with a ferromagnetic material in which lies the spiral inductor, connected by via to underpass contact; and/or a second spiral inductor either above or adjacent to the first, the two coils being connected to each other by a ferromagnetic bridge and externally, if stacked, by an overpass. The toroidal inductor is similarly formed in dielectric trenches lined with ferromagnetic material, the coils being segmented to reduce eddy currents and the segments being separated from each other by dielectric, increasing the Q. Studs connect the opposite ends. The ferromagnetic bridge and dummy central structures or air core are stated to increase the Q by reducing flux penetration into the substrate thereby increasing inductance. Use of copper, a low resistance material, in thick interconnects reduces parasitic resistance, further increasing Q. (Aluminum has generally been used.) The patent describes results of Q = 40 @ 5.8 GHz for a 1.4 nH inductor and Q =13 @ 600 MHz for a 80 nH inductor, twice or triple the Q than conventional silicon-based integrated inductors.

US patent 6,037,649 to Liou describes a a three-dimensional coil inductor structure, optionally including a shielding ring, which comprises N-turn coil lines in three levels, separated from each other and the substrate by isolating layers and connected through vias. It is described that the structure of the invention, in which the magnetic field is normal to the substrate, provides lower series resistance than a flat structure, less effect on the other components of the IC, lower parasitic capacitance and higher Q at RF and microwave frequencies.

US patent 5,559,360 to Chiu et al. describes a multilevel multielement structure that maintains a constant distance between parallel conductive elements, thereby equalizing each element's resistance. The solution is intended to minimize current crowding, especially at conductor widths beyond 15 microns, and maximize self-inductance between conductive elements, possibly raising the Q to 15 for Al conductor over Si substrate.

US patent 5,446,311 to Ewen et al. describes a multilevel inductor constructed on a silicon substrate which is layered with insulating oxide. The inductors are connected in parallel to avoid series resistance and the metal levels are shunted by vias. A Q of 7 at 2.4 GHz is reported.

US patent 6,124,624 to Van Roosmalen et al. describes a multilevel inductor comprised of closely spaced stacks of parallel connected elongated rectangular strips in which bridging crossover and/or cross/under is avoided. The levels are separated by silicon dioxide. The structure is stated to raise the Q , possibly over 25 @ 2 GHz, by a reduction of series resistance using various series and parallel connections through vias and by enhanced mutual inductance of layered strips. A staggered stacking is stated to contribute to high Q by reducing parasitic capacitance.

US patent 6,146,958 to Zhao et al. describes a reduction in series resistance, hence an increase in Q, by connecting a spiral inductor at a lower level to one at a higher level by a continuous via.

Another approach to improving the Q factor is to create shielding or zones within the IC which include materials, or open space, that control or limit the extent that electromagnetic lines can penetrate the IC, thereby reducing substrate losses. US patent 6,169,008B1 to Wen et al. describes forming a 3-5 micron deep trench in the dielectric substrate of an IC, and filling the trench with a high resistivity epitaxy layer which has a lower dopant concentration than the substrate by several orders of magnitude and will therefor act as a dielectric. The epitaxy layer is etched back, a dielectric layer is deposited over all and the inductor windings on the dielectric layer, thereby increasing the resistivity between the substrate and the windings and increasing Q.

A publication "Large Suspended Inductors on Silicon and Their Use in a 2 micron CMOS RF Amplifier" in IEEE Electron Device Letters, Vol. 14, No. 5 by Chang et al. describes creating a high-Q spiral inductor by selectively etching a 200-500 micron deep cavity underneath a spiral inductor to minimize substrate losses and raise Q.

US patent 5,959,522 to Andrews describes a structure having upper and lower high magnetic permeability, i.e. greater than about 1.1, shielding layers between which is a layer comprising a spiral induction coil, optionally including an annular ring. Through an open central area designed to reduce series resistance, eddy currents and dissipative resistive currents the shielding layers are coupled to each other and concentrate the current-induced magnetic flux. The concentration of magnetic flux permits increased inductance in a smaller area. A pattern of radial projections of the shielding layers increases the effective conductance. If the lower shielding level is nonconductive, it also functions as electrical shielding to the substrate, and raise Q.

US patent 5,760,456 to Grzegorek et al. describes the interposition of a patterned segmented conductive plane, having an oxide insulating layer covering both top and bottom surfaces, which functions as an electrostatic shield between the substrate level and the spiral inductor level. The conductive plane, which includes a perimeter region electrically connected to a fixed low impedance reference voltage, comprises metal, polysilicon or a heavily doped region of the substrate. Provided its distance from the inductor is sufficient, the design and location of the conductive plane is said to minimize parasitic capacitance, the flow of eddy currents and inhibit the flow of the electric field current to the substrate, increasing the Q, while minimizing the surface area of the inductor also minimizes the series resistance, increasing the Q. It is stated that the invention provides a Q of up to about 6 at a frequency of about 2 GHz.

US patent 5,918,121 to Wen et al. maintains the concept of a flat spiral inductor over a silicon substrate and focuses on minimizing loss between the inductor and the substrate by forming an epitaxial area having a resistivity of thousands of ohm-cm, such as silicon lightly doped with such materials as arsenic and phosphorous. The epitaxial area lies surrounded on the top and sides by an oxide insulator and atop the substrate, which has a resistivity of about 10 to about 20 ohm-cm. The planar inductor, which is enclosed on the top and sides by an intermetalic dielectric, lies directly on the that part of the oxide layer which is directly on top of epitaxial area. The stated result is a reduction of loss of induction current to the substrate, and improved Q.

US patent 6,153,489 to Park et al. describes forming a trench within the silicon substrate which is filled with an insulating porous silicon, which is a high resistivity material, coating with a dielectric layer on which is formed a lower metal line and a second dielectric layer followed by a spiral inductor pattern which is connected to the metal line by a via. Alternatively, the spiral can be formed within the porous silicon layer. In another alternative a high concentration of dopants of the opposite conductivity type to that of the substrate is implanted in the trench before filling the trench with porous silicon, and forming a polysilicon trench electrode at a point adjacent to and connected with the porous silicon. Instead of ion implanting to form a conductive doped layer, highly doped polysilicon can be used. Application of a reverse bias voltage between the substrate and the doped layer creates a P-N junction depletion layer in the substrate. The resulting structure is stated to further decrease parasitic capacitance and minimize loss from metal levels to substrate, increasing the Q.

Another approach to improving the Q factor is redesign of IC real estate. US patent 5,959,515 to Cornett et al. describes effectively reducing the cross-under length of the inductor, i.e. the length of the conductor line between the inner turn of the spiral inductor to the outside connection, by leaving open a center around which is loosely wrapped the turns of the spiral inductor. The patent describes remote placement of devices from the L-C tank circuit to eliminate cross under and parasitic interconnection resistance in a resonator, enhancing Q.

Patent Abstracts of Japan publication number 2000 022085A in the name of Toshiba Corporation discloses a semiconductor device where elements close to each other are prevented from affecting each other and from degrading in inductance and Q value by the following solution. A shielding layer is made to confront an inductor which forms an analogue circuit formed on an element isolating region of a semiconductor substrate so as to be arranged between the inductor and an element isolating region which is isolated from the inductor by a prescribed distance. The shileding layer is formed of a high-resistance polysilicon, single crystal silicon or amorphous silicon. An impurity diffusion region whose conductivity-type is opposite to that of a well under an element isolation region is made to serve as a shielding layer.

The structure and process of the present invention is not described in the related art. The well in the present invention is created deep into the substrate. The position of the shield in the substrate with an insulating layer below and a low-k dielectric filling the deep well above it minimizes the parasitic capacitive coupling to the substrate and to devices. Reduction of the parasitic capacitance increases the self-resonating frequency of the spiral inductor, resulting in increased Q. The dielectric layers in the present invention do not need to be thick overall, necessitating high aspect ratio connecting vias, in order to reduce capacitive coupling to the substrate. In the present invention the capacitive coupling between the inductor and the substrate is reduced by increasing the dielectric thickness only directly under the inductor and at a uniform distance from each turn of the inductor. Placing the shield in the bottom of the dielectric-filled well in the present invention lowers the parasitic capacitance between the inductor and the shield, which increases the self resonant frequency of the inductor spiral. The elongated segmented shape of the shield reduces addy currents. The process of the present invention can be smoothly integrated into new and existing technologies. Increasing the spacing between the inductor coil and the substrate using a true, organic dielectric decreases parasitic capacitance, and the placing of a patterned conductive shield (ground plane) on the substrate at the bottom of well terminates any remaining parasitic field before it reaches the substrate. The two contributions taken together increase the Q. Other advantages will be apparent to one skilled in the art.

### SUMMARY OF THE INVENTION

The present invention provides an inductor device according to present claim 1 and a method according to claim 14. Preferred embodiments are described in dependent claims.

An object of the invention is to provide within an IC structure a high-Q inductor suitable for use in a high frequency environment.
A further object of the invention is to maximize the value of Q of an integrated inductor by eliminating the losses caused by the penetration of parasitic electrical fields emanating from the inductor into the substrate.

A further object of the invention is to achieve the above objects using processes and materials which are compatible with those conventionally employed in IC manufacturing.
These and additional objects are achieved in the present invention in which the capacitive coupling from the inductor to the substrate is eliminated by providing a well filled with organic low dielectric constant (k) material below the inductor and providing a grounded patterned Faraday shield at the bottom of the low-k well. The invention may be fabricated on a bare silicon substrate or on an FEOL, or on SiGe, HRS (high resistivity silicon), or a device wafer such as CMOS or BiCMOS, and the like. Other substrate materials, such as GaAs, quartz, and the like could be used if the method of etching the well is modified accordingly.

### BRIEF DESCRIPTION OF THE DRAWINGS

Fig. 1 is an equation which defines Q.
Fig. 2A shows the context in cross section and rotated 90 degrees in which well (1) shown in 2B is to be located.
Fig. 3A shows in cross-section and rotated 90 degrees the well which is shown in Fig. 2B after applying insulator (8), conductor (9) and photoresist mask (7) and patterning the conductor (9) and mask (7) to form the groundplane (Faraday shield) (2) shown in 3B.
Fig. 3C shows an alternative formation of the ground shield conductive region 9 by doping the the silicon at the bottom of the well through a masked pattern (photoresist mask 7) .
Fig. 4A shows the well and groundplane (2) of Fig. 3B after filling the entire well with a low-k organic dielectric (4); two sides and the bottom are shown as open for understanding of the shield position. 4B shows the same in cross-section at 90 degrees rotation after planarizing.
Fig. 5 shows the filled well of Fig. 4A in relation to the spiral inductor (5) integrated in the standard BEOL (Back-End-Of-Line) processing (intermediate process steps and layers of interconnects, vias and insulators have not been included in this figure) .
Fig. 6 shows the structure of Fig. 5 after adding open vias (6) in preparation for the alternate embodiment shown in Fig. 7.
Fig. 7 shows the structure of Fig. 6 after the organic dielectric (4) has been removed from the well through the open vias (6), leaving air dielectric.

### DETAILED DESCRIPTION OF THE INVENTION

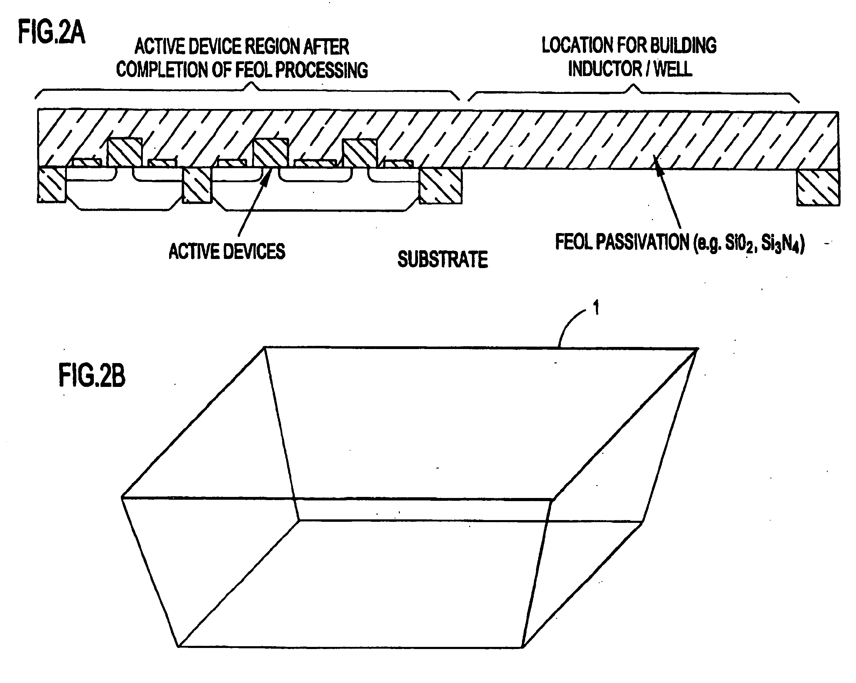

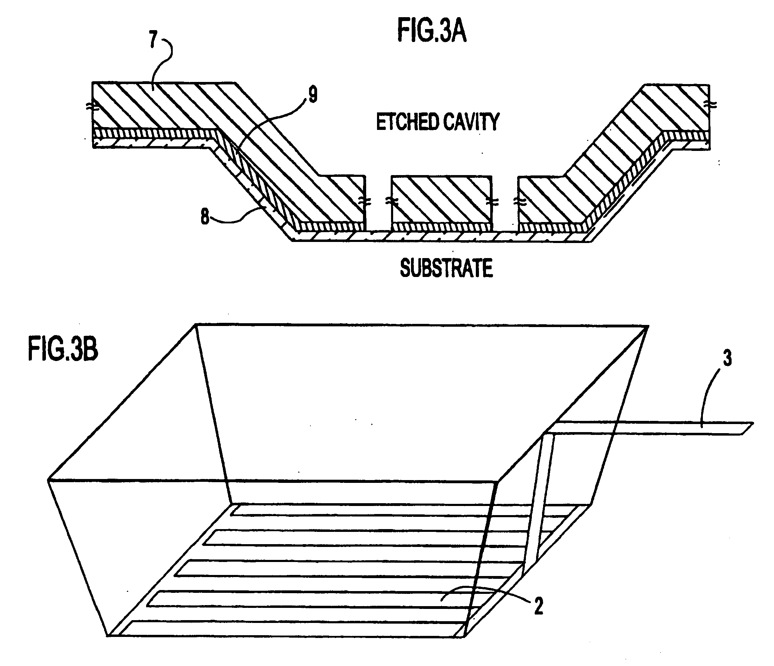

A wider choice of material will be available for filling the wells in a structure intended for BEOL if fabrication of the FEOL (front-end-of-line) processing, i.e. the silicon substrate and active devices thereon shown in Fig. 2A, preferably is first completed. In that way the well structure does not risk exposure to subsequent processing that may equal or exceed 400 degrees C. Beginning, then, with the FEOL silicon substrate which is coated with a passivation/insulation layer such as SiO2, Si3N4, or BPSG (boron-phosphorous doped silicate glass), a well is patterned to correspond to an area which is marginally larger than that of the of the intended inductor and directly below it. The pattern for the well is etched through an opening in a mask which will withstand the etchant into the silicon substrate using means such as reactive ion etching (RIE) or wet etching with a solution of TMAH (tetramethylammonium hydroxide), KOH (potassium hydroxide), EDP (ethylenediaminepyrochatechol) or other etchant selective for the particular substrate composition, until a well which is about 20 microns deep is formed, as seen in Fig. 2B. The side walls of the well should have sufficient slope both to facilitate wall coverage by insulator (8), conductor (9) and photoresist (7) as shown in Fig. 3A and the formation of the ground shield (2) shown in 3B and 3C.

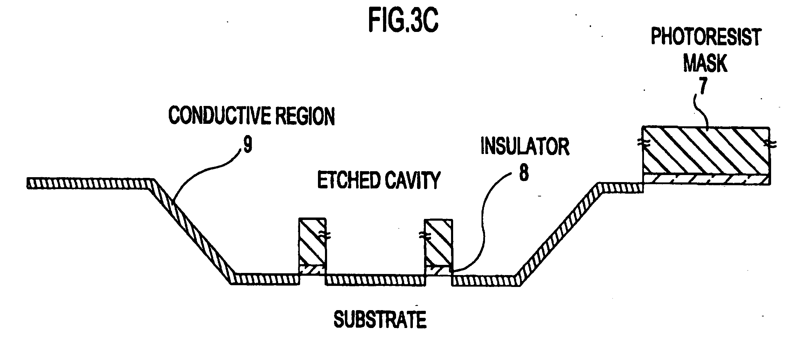

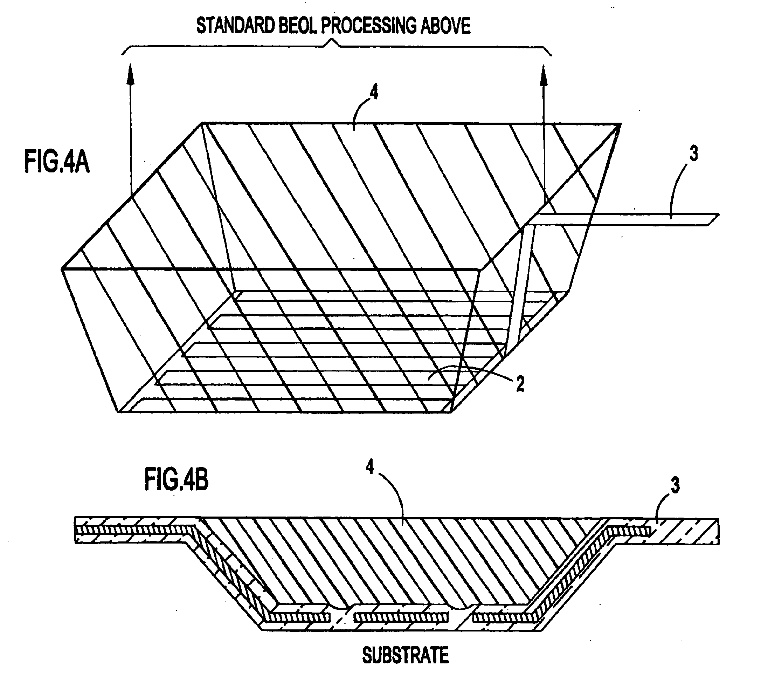

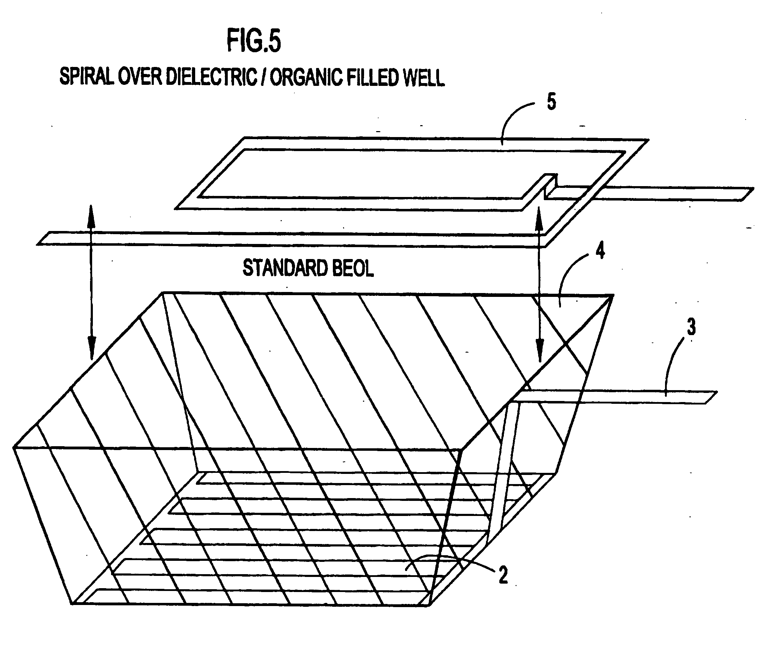

The bottom and sides of the well are then coated with a second passivation/insulation layer (8) of SiO2, Si3N4, BPSG or other such material, followed by a layer of conductive material (9) such as metal, doped a-silicon, doped polysilicon or silicide. Photoresist (7), such as AZ-4611, is applied over the conductive material and an elongated, segmented pattern for the Faraday ground shield (2) is opened down to the insulator (8). The pattern prevents the generation of eddy currents in the shield. A connection to ground (3) up a side of the well is also exposed, developed and etched as seen in Fig. 3B. Alternatively, the ground shield could be formed by doping the silicon at the bottom of the well through a masked pattern to make the doped area more conductive with respect to the substrate as shown in Fig. 3c . A low dielectric constant (k) material, such as polyimide 2560 or SiLK (4), is applied to completely fill the well. The filling of the well is indicated in Fig. 4A; however two walls are left open in the drawing for ease of visualization. The filled well is shown rotated in cross-section in Fig. 4B. For a well which is about 20 microns deep, 25 microns of polyimide would be appropriate to overfill the well and coat the surface of the wafer outside the well. The dielectric is then cured, if polyimide, to 400 degrees C, and if the surface across the wafer and filled well is uneven it is made even by CMP, such as polishing with an alumina slurry, stopping at the passivation/insulation layer on the surface outside the well as shown in Fig. 4B. This step in the process may have to be repeated to ensure coplanarity of the surface of the filled well with the surrounding passivation/insulation layer surface. The planar inductor coil (5) is formed over the filled well as shown in Fig. 5. Additional process steps are taken to fabricate the complete IC structure desired.

Decreasing parasitic capacitance between the spiral and the substrate without the addition of prohibitively thick dielectric layering, and providing a Faraday shield ground plane which eliminates any remaining parasitic capacitance in addition to its being shaped to avoid eddy current problems, results in a robust IC structure which includes a low loss spiral inductor having a high Q at RF and microwave frequencies.

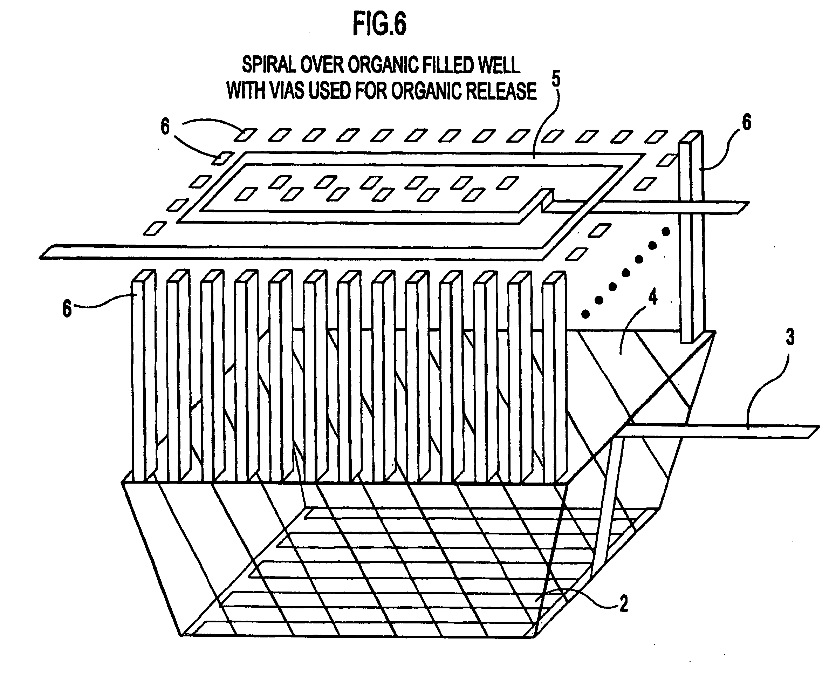

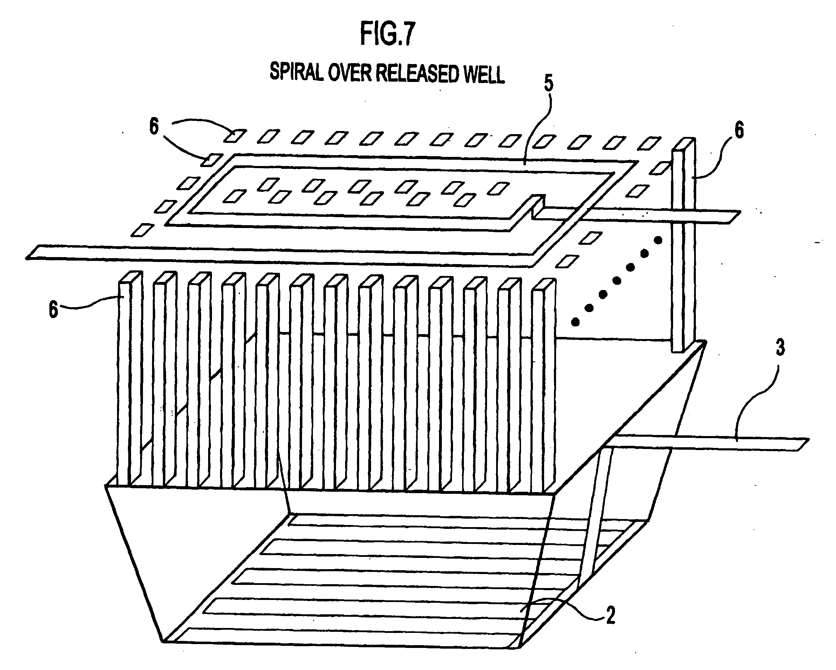

In an alternate embodiment of the invention, after the formation of the inductor coil a pattern is etched between the coils of the inductor to form empty air space in the well below the inductor. Using RIE, the dielectric in the well is removed from under the inductor through open vias, as shown in Fig. 6 and Fig. 7, leaving an air dielectric in the well.

While the invention has been shown and described in particular embodiments, variations in process steps, materials and structures will be obvious to those skilled in the art.

## Claims

1. A device for an integrated circuit, comprising:
a. a semiconductor substrate;
b. a well (1) in the substrate, the well (1) having a floor;
c. a conductive ground shield (2) disposed planarily on the well floor; and
d. an inductor (5) disposed above the well (1) and parallel to the shield (2) ;
**characterised in that**,
the well (1) is filled with a low-k dielectric material (4).

2. The device recited in claim 1, wherein the substrate comprises a FEOL, CMOS or BiCMOS substrate.

3. The device recited in claim 1, wherein the substrate comprises silicon, GaAs, HRS, quartz, sapphire, or SiGe.

4. The device recited in claim 1, wherein the well (1) is about 20 microns deep.

5. The device recited in claim 1, wherein the well (1) is slope-walled.

6. The device recited in claim 1, wherein the low-k dielectric material (4) comprises a polyimide, SiLk or air.

7. The device recited in claim 1, wherein the conductive ground shield (2) is comprised of separate elongated coplanar segments which are connected commonly and to ground at one end.

8. The device recited in claim 7, wherein the conductive ground shield (2) is comprised of a metal, doped silicon, doped polysilicon or silicide.

9. The device recited in claim 1, wherein the conductive ground shield (2) is separated from the substrate by passivation/insulation material.

10. The device recited in claim 9, wherein the passivation/insulation material is SiO2, Si3N4 or BPSG.

11. The device recited in claim 1, wherein the inductor (5) is a spiral planar inductor.

12. The device recited in claim 1, wherein the inductor (5) is separated from the conductive ground shield (2) by a passivation/insulation material.

13. The device recited in claim 12, wherein the passivation/insulation material is SiO2, Si3N4 or BPSG.

14. A method of making an integrated inductor for a low loss IC comprising:
a. providing a semiconductor substrate which is coated with a first passivation/insulation layer (8);
b. patterning a well in the first passivation/insulation layer (8) and etching the well (1) having walls and a floor through an area on the substrate which is preselected to be marginally larger than an inductor (5) intended to be directly above the well(1) ;
c. covering the wells and floor of the well in turn with a second passivation/insulation layer (8), a conductor (9) and a mask (7) ;
d. etching through the mask (7) a ground shield (2) having a connection to outside the well (1) ;
e. conformally applying a third passivation/insulation layer (8) to the walls of the well (1) and the etched ground shield (2);
**characterised by**
f. filling the well (1) level with low-k dielectric material (4), and continuing process steps to complete the IC, including the step of fabricating an inductor (5) directly vertically above the wall (1)

15. The method recited in claim 14, wherein the step of providing a semiconductor substrate comprises providing a substrate comprising Si, GaAs, HRS, quartz, sapphire, or SiGe.

16. The method recited in claim 14, wherein the step of providing a semiconductor substrate comprises providing an FEOL as a substrate.

17. The method recited in claim 14, wherein the passivation/insulation layers (8) comprise SiO2, Si3N4 or BPSG.

18. The method recited in claim 14, wherein the step of etching a well (1) having walls and a floor comprises etching a well (1) having sloped walls and a floor using wet etching with an etchant selective to the substrate material.

19. The method recited in claim 18, wherein the step of using wet etching a well comprises using TMAH with a silicon substrate.

20. The method recited in claim 14, wherein the step of covering the walls and floor of the well (1) with a conductor (9) comprises covering the walls and floor of the well (1) with a metal, doped silicon, doped polysilicon or silicide.

21. The method recited in claim 14, wherein the step of covering the walls and floor of the well (1) with a mask (7) comprises covering the walls and floor of the well (1) with cured photoresist having continuity outside the well (1).

22. The method recited in claim 14, wherein the step of filling the well (1) with low-k dielectric material (4) comprises filling the well (1) with a low-k cured polyimide.

23. The method recited in claim 14, wherein the well (1) is filled with an organic dielectric and the step of continuing process steps to complete the IC and of fabricating an inductor (5) includes the steps of etching between the turns of the inductor (5) openings which extend down into the well (1), and removing the organic dielectric by reactive ion etching.

## Patentansprüche

1. Vorrichtung für eine integrierte Schaltung, welche das Folgende umfasst:
a. ein Halbleitersubstrat;
b. eine Wanne (1) in dem Substrat, wobei die Wanne (1) einen Boden aufweist;
c. einen leitfähigen Masseschirm (2), welcher auf dem Wannenboden planar angeordnet ist; und
d. einen Induktor (5), welcher über der Wanne (1) und parallel zu der Abschirmung (2) angeordnet ist;
**dadurch gekennzeichnet, dass**
die Wanne (1) mit einem Material (4) mit niedriger Dielektrizitätskonstante k gefüllt ist.

2. Vorrichtung nach Anspruch 1, wobei das Substrat ein FEOL-, CMOS- oder BiCMOS-Substrat umfasst.

3. Vorrichtung nach Anspruch 1, wobei das Substrat Silicium, GaAs, HRS (High Resistivity Silicon, Silicium mit hohem spezifischen Widerstand), Quartz, Saphir oder SiGe umfasst.

4. Vorrichtung nach Anspruch 1, wobei die Wanne (1) ungefähr 20 Mikrometer tief ist.

5. Vorrichtung nach Anspruch 1, wobei die Wanne (1) eine abgeschrägte Wand aufweist.

6. Vorrichtung nach Anspruch 1, wobei das Material (4) mit niedriger Dielektrizitätskonstante k ein Polyimid, SiLK oder Luft umfasst.

7. Vorrichtung nach Anspruch 1, wobei der leitfähige Masseschirm (2) aus einzelnen länglichen coplanaren Segmenten besteht, welche miteinander verbunden sind und an einem Ende mit Masse verbunden sind.

8. Vorrichtung nach Anspruch 7, wobei der leitfähige Masseschirm (2) aus einem Metall, aus dotiertem Silicium, aus dotiertem Polysilicium oder aus Silicid besteht.

9. Vorrichtung nach Anspruch 1, wobei der leitfähige Masseschirm (2) durch Passivierungs/Isolierungs-Material von dem Substrat getrennt ist.

10. Vorrichtung nach Anspruch 9, wobei es sich bei dem Passivierungs/Isolierungs-Material um SiO₂, Si₃N₄ oder BPSG handelt.

11. Vorrichtung nach Anspruch 1, wobei es sich bei dem Induktor (5) um einen spiralförmigen planaren Induktor handelt.

12. Vorrichtung nach Anspruch 1, wobei der Induktor (5) durch ein Passivierungs/Isolierungs-Material von dem leitfähigen Masseschirm (2) getrennt ist.

13. Vorrichtung nach Anspruch 12, wobei es sich bei dem Passivierungs/Isolierungs-Material um SiO₂, Si₃N₄ oder BPSG handelt.

14. Verfahren zur Herstellung eines integrierten Induktors für einen verlustarmen IC, wobei das Verfahren das Folgende umfasst:
a. Bereitstellen eines Halbleitersubstrats, welches mit einer ersten Passivierungs/Isolierungs-Schicht (8) beschichtet ist;
b. Strukturieren einer Wanne in der ersten Passivierungs/Isolierungs-Schicht (8) und Ätzen der Wanne (1), welche Wände und einen Boden aufweist, durch einen Bereich auf dem Substrat, welcher vorab so gewählt wird, dass er geringfügig größer ist als ein Induktor (5), der direkt über der Wanne (1) angeordnet sein soll;
c. Bedecken der Wände und des Bodens der Wanne der Reihe nach mit einer zweiten Passivierungs/Isolierungs-Schicht (8), einem Leiter (9) und einer Maske (7);
d. Ätzen eines Masseschirms (2), welcher eine Verbindung zur Außenseite der Wanne (1) aufweist, durch die Maske (7);
e. konformes Aufbringen einer dritten Passivierungs/Isolierungs-Schicht (8) auf die Wände der Wanne (1) und den geätzten Masseschirm (2);
**gekennzeichnet durch**
f. vollständiges Füllen der Wanne (1) mit einem Material (4) mit niedriger Dielektrizitätskonstante k und Durchführen weiterer Verfahrensschritte, um den IC fertig zu stellen, einschließlich des Schrittes des Herstellens eines Induktors (5) unmittelbar vertikal über der Wanne (1).

15. Verfahren nach Anspruch 14, wobei der Schritt des Bereitstellens eines Halbleitersubstrats das Bereitstellen eines Halbleitersubstrats umfasst, welches Si, GaAs, HRS, Quartz, Saphir oder SiGe umfasst.

16. Verfahren nach Anspruch 14, wobei der Schritt des Bereitstellens eines Halbleitersubstrats das Bereitstellen eines FEOL als Halbleitersubstrat umfasst.

17. Verfahren nach Anspruch 14, wobei die Passivierungs/Isolierungs-Schichten (8) SiO₂, Si₃N₄ oder BPSG umfassen.

18. Verfahren nach Anspruch 14, wobei der Schritt des Ätzens einer Wanne (1), welche Wände und einen Boden aufweist, das Ätzen einer Wanne (1) umfasst, welche abgeschrägte Wände und einen Boden aufweist, wobei eine Nassätztechnik mit einem Ätzmittel angewendet wird, welches für das Substratmaterial selektiv ist.

19. Verfahren nach Anspruch 18, wobei das Ätzen einer Wanne unter Anwendung der Nassätztechnik die Verwendung von TMAH mit einem Siliciumsubstrat umfasst.

20. Verfahren nach Anspruch 14, wobei der Schritt des Bedeckens der Wände und des Bodens der Wanne (1) mit einem Leiter (9) das Bedecken der Wände und des Bodens der Wanne (1) mit einem Metall, mit dotiertem Silicium, mit dotiertem Polysilicium oder mit Silicid umfasst.

21. Verfahren nach Anspruch 14, wobei der Schritt des Bedeckens der Wände und des Bodens der Wanne (1) mit einer Maske (7) das Bedecken der Wände und des Bodens der Wanne (1) mit gehärtetem Fotoresist umfasst, welcher sich außerhalb der Wanne (1) fortsetzt.

22. Verfahren nach Anspruch 14, wobei der Schritt des Füllens der Wanne (1) mit einem Material (4) mit niedriger Dielektrizitätskonstante k das Füllen der Wanne (1) mit einem gehärteten Polyimid mit niedriger Dielektrizitätskonstante k umfasst.

23. Verfahren nach Anspruch 14, wobei die Wanne (1) mit einem organischen Dielektrikum gefüllt wird und der Schritt der Durchführung weiterer Verfahrensschritte zur Fertigstellung des IC und des Herstellens eines Induktors (5) die Schritte des Ätzens von Öffnungen, welche sich nach unten bis in die Wanne (1) erstrecken, zwischen den Windungen des Induktors (5) und des Entfernens des organischen Dielektrikums durch reaktives Ionenätzen umfasst.

## Revendications

1. Dispositif pour un circuit intégré, comprenant :
a. un substrat semi-conducteur ;
b. un puits (1) dans le substrat, le puits comprenant un plancher ;
c. un blindage (2) conducteur, disposé de manière plane sur le plancher de puits, et
d. une inductance (5), disposée au-dessus du puits (1) et parallèlement au blindage (2) ;
**caractérisé en ce que**
le puits (1) est rempli avec un matériau diélectrique (4) à facteur k de faible valeur.

2. Dispositif selon la revendication 1, dans lequel le substrat comprend un substrat FEOL, CMOS ou BiCMOS.

3. Dispositif selon la revendication 1, dans lequel le substrat comprend du silicium, GaAs, HRS, du quartz, du saphir ou du SiFe.

4. Dispositif selon la revendication 1, dans lequel le puits (1) est d'une profondeur d'à peu près 20 microns.

5. Dispositif selon la revendication 1, dans lequel le puits (1) est à parois inclinées.

6. Dispositif selon la revendication 1, dans lequel le matériau diélectrique (4) à facteur k de faible valeur comprend un polyimide, du SiLK ou de l'air.

7. Dispositif selon la revendication 1, dans lequel le blindage (2) conducteur est composé de segments coplanaires allongés séparés, connectés conjointement et à la masse à une extrémité.

8. Dispositif selon la revendication 7, dans lequel le blindage (2) conducteur est composé d'un métal, de silicium dopé, de polysilicium ou de siliciure.

9. Dispositif selon la revendication 1, dans lequel le blindage (2) conducteur est séparé du substrat par un matériau de passivation/isolation.

10. Dispositif selon la revendication 9, dans lequel le matériau de passivation/isolation est le SiO₂, Si₃N₄ ou BPSG.

11. Dispositif selon la revendication 1, dans lequel l'inductance (5) et une inductance plane en spirale.

12. Dispositif selon la revendication 1, dans lequel l'inductance (5) est séparée du blindage (2) conducteur par un matériau de passivation/isolation.

13. Dispositif selon la revendication 12, dans lequel le matériau de passivation/isolation est le SiO₂, Si₃N₄ ou BPSG.

14. Procédé de fabrication d'une inductance intégrée pour un IC à faibles pertes, comprenant :
a. la fourniture d'un substrat semi-conducteur, revêtu d'une première couche de passivation/isolation (8) ;
b. mise en motif d'un puits (1) dans la première couche de passivation/isolation (8) et gravure du puits (1) ayant des parois et un plancher dans une zone, sur le substrat, présélectionnée pour être marginalement plus grande qu'une inductance (5) destinée à être située directement au-dessus du puits (1) ;
c. couverture des parois et du plancher du puits, tout à tour avec une deuxième couche de passivation/isolation (8), un matériau conducteur (9) et un masque (7) ;
d. gravure, à travers le masque (7), d'un blindage (2) ayant une connexion vers l'extérieur du puits (1) ;
e. application conforme d'une troisième couche de passivation/isolation (8) sur les parois du puits (1) et le blindage (2) gravé ;
**caractérisé par**
f. le remplissage du puits (1), de niveau avec le matériau diélectrique (4) à facteur k de faible valeur, et continuation des étapes de traitement, pour achever le IC, y compris l'étape de fabrication d'une inductance (5), directement verticalement au-dessus du puits (1).

15. Procédé de fabrication selon la revendication 14, dans lequel l'étape de fourniture d'un substrat semi-conducteur comprend la fourniture d'un substrat comprenant du Si, GaAs, HRS, du quartz, du saphir ou du SiFe.

16. Procédé de fabrication selon la revendication 14, dans lequel l'étape de fourniture d'un substrat semi-conducteur comprend la fourniture d'un FEOL en tant que substrat.

17. Procédé de fabrication selon la revendication 14, dans lequel les couches de passivation/isolation (8) comprennent du SiO₂, Si₃N₄ ou BPSG.

18. Procédé de fabrication selon la revendication 14, dans lequel l'étape de gravure d'un puits ayant des parois et un plancher comprend la gravure d'un puits (1) ayant des parois inclinées et un plancher, en utilisant une gravure par voie humide avec un agent de gravure sélectif envers le matériau du substrat.

19. Procédé de fabrication selon la revendication 18, dans lequel l'étape d'utilisation de gravure par voie humide d'un puits comprend l'utilisation de TMAH avec un substrat en silicium.

20. Procédé de fabrication selon la revendication 14, dans lequel l'étape de couverture des parois et du plancher du puits (1) avec un matériau conducteur (9) comprend la couverture des parois et du plancher du puits (1) avec un métal, du silicium dopé, du polysilicium dopé ou un siliciure.

21. Procédé de fabrication selon la revendication 14, dans lequel l'étape de couverture des parois et du plancher du puits (1) avec un masque (7) comprend la couverture des parois et du plancher du puits (1) avec une photoréserve polymérisée, présentant une continuité à l'extérieur du puits (1).

22. Procédé de fabrication selon la revendication 14, dans lequel l'étape de remplissage du puits (1) avec un matériau diélectrique (4) à facteur k de faible valeur comprend le remplissage du puits (1) avec un polyimide à facteur k de faible valeur polymérisé.

23. Procédé de fabrication selon la revendication 14, dans lequel le puits (1) est rempli d'un diélectrique organique et l'étape de continuation des étapes pour achever le IC et de fabrication d'une inductance (5) comprend les étapes de gravure, entre les spires de l'inductance (5), d'ouvertures s'étendant en descendant dans le puits (1), et d'enlèvement du diélectrique organique par gravure avec des ions réactifs.
